# EUROPÄISCHE PATENTANMELDUNG

(11) **EP 1 753 140 A1**
(43) Veröffentlichungstag der Anmeldung: **14.02.2007**
(21) Anmeldenummer: 05017692.4
(22) Anmeldetag: 13.08.2005
(51) Int. Cl.: H03M 1/16, G01D 5/14, H02K 29/00

(54) **Elektronisch kommutierter Gleichstrom-Servomotor**

(71) Anmelder: Spezialantriebstechnik GmbH, 04746 Hartha (DE)
(72) Erfinder: Herrmann, Otto, 04746 Hartha (DE)
(74) Vertreter: GROSSE BOCKHORNI SCHUMACHER

(57) **Zusammenfassung**

Ein elektronisch kommutierter Gleichstrom-Servomotor 18, bei welchem ein von der Motorwelle 8 angetriebenes untersetzendes Stirnzahnrad-Messgetriebe 1 mit zur Motorwelle 8 parallel gelagerten ersten, zweiten und gegebenenfalls weiteren Radwellen 25, 27 sowie eine Mikroprozessorsteuerung 17 im Motorgehäuse 30 integriert sind, besitzt an der Stirnseite der Motorwelle 8 und mindestens einer Radwelle 25, 27 erste, zweite und gegebenenfalls weitere permanentmagnetische Geber 9, 11, 14, denen in relativ geringem Abstand fest angeordnete erste, zweite und gegebenenfalls weitere Winkelsensoren 10, 13, 15 gegenüberliegen, deren Ausgänge mit den Eingängen der Mikroprozessorsteuerung 17 elektrisch verbunden sind, und die Positionsauflösung der Winkelsensoren 10, 13, 15 beträgt mindestens vierundsechzig Inkremente auf 360°.

## Beschreibung

Die Erfindung betrifft einen elektronisch kommutierten Gleichstrom-Servomotor, welcher z. B. in Stellantrieben für Förderanlagen, Handhabungsvorrichtungen, Robotern usw. Anwendung findet. Um die Bewegungen derartiger Anlagen und Aggregate mit hoher Präzision steuern zu können, muss die absolute Winkelposition der Motorwelle über eine Vielzahl von Umdrehungen bestimmbar sein. Zur Bestimmung der Absolutposition der Motorwelle derartiger Motoren wurden nach dem Stand der Technik zum einen so genannte Multiturn-Drehgeber verwendet, wie sie z. B. in EP 1 076 809 B1 beschrieben sind. Solche Multiturn-Drehgeber umfassen einen ersten Sensor, der die absolute Winkelposition der Motorwelle innerhalb einer Umdrehung erfasst, sowie mindestens einen weiteren Sensor, der über ein Untersetzungsgetriebe die Anzahl der Umdrehungen der Motorwelle erfasst. Diese Multiturn-Drehgeber sind für kleine Antriebe zu groß. Außerdem ist ihre Herstellung relativ aufwendig, weil für eine präzise Bestimmung der absoluten Winkelposition auch ein hochpräzises mechanisches Untersetzungsgetriebe erforderlich ist.

In der DE 103 46 052 A1 ist zum anderen eine Vorrichtung zur Erfassung der Absolutposition einer Welle beschrieben, bei welcher die Positionsbestimmung direkt im Motor erfolgt. Diese Lösung hat den Nachteil, dass die Mechanik zu kompliziert und damit ebenfalls zu teuer ist. Außerdem wird bei Anordnung der kompletten Motorsteuerung im Motor zu viel Platz beansprucht.

Es ist daher Aufgabe der Erfindung, einen elektronisch kommutierten Gleichstrom-Servomotor zu entwickeln, bei welchem die Einrichtung zur Bestimmung der absoluten Winkelposition der Motorwellen im Motorgehäuse integriert ist und welche mit minimalen Kosten herstellbar ist.

Die Aufgabe wird erfindungsgemäß durch die Merkmale des Patentanspruches 1 gelöst.

Vorteilhafte Ausführungsformen der Erfindung bilden die Merkmale der Unteransprüche 2 bis 4.

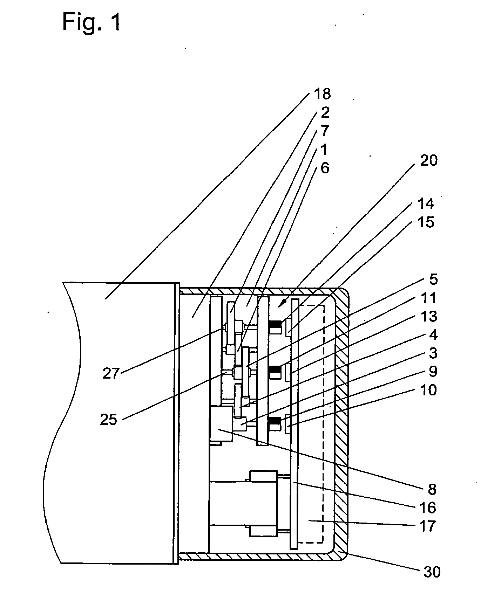

Die Erfindung soll im Folgenden anhand eines bevorzugten Ausführungsbeispiels unter Bezugnahme auf die Tabelle 1 sowie die Figur 1 näher erläutert werden.

Fig. 1 zeigt einen elektronisch kommutierten Gleichstrom-Servomotor 18 in einer teilweise aufgebrochenen Seitenansicht. Das Messgetriebe 1 ist mit einem Motorflansch 2 fest verbunden und besteht aus einem mehrstufigen Stirnradgetriebe mit einem ersten Zahnrad 3, einem zweiten Zahnrad 4, einem dritten Zahnrad 5, einem vierten Zahnrad 6 und einem fünften Zahnrad 7. In geringem Abstand zum Messgetriebe 1 befindet sich eine Leiterplatte 16 mit einer Mikroprozessorsteuerung 17, die auch eine komplette Steuerung des Motors 18 einschließlich einer Leistungsendstufe enthält. Das erste Zahnrad 3 ist mit einer Motorwelle 8 des elektronisch kommutierten Gleichstrom-Servomotors 18 verbunden und trägt an seiner Stirnseite einen ersten permanentmagnetischen Geber 9. Der erste permanentmagnetische Geber 9 dient in Verbindung mit einem ersten Winkelsensor 10 zur Bestimmung der absoluten Position der Motorwelle 8 innerhalb einer Umdrehung und ist zur Ansteuerung der Motorwicklungen erforderlich. Weiterhin treibt das erste Zahnrad 3 über das zweite Zahnrad 4 das dritte Zahnrad 5 mit einem Untersetzungsverhältnis von 16:1 an. Ein zweiter permanentmagnetischer Geber 11 ist über eine erste Welle 25 mit dem Zahnrad 5 verbunden und zählt in Verbindung mit einem zweiten Winkelsensor 13 die Anzahl der Motorumdrehungen von 0 bis 15. Zur Erhöhung des Zählbereiches der Umdrehungen wird ein dritter permanentmagnetischer Geber 14 über das vierte Zahnrad 6 und das fünfte Zahnrad 7 vom dritten Zahnrad 5 mit einem Untersetzungsverhältnis von 16:1 angetrieben. Ein dritter Winkelsensor 15 kann ebenfalls die Umdrehungen des dritten permanentmagnetischen Gebers 14 von 0 bis 15 zählen.

Durch die Kaskadierung der zweiten und dritten Winkelsensoren 13 und 15 kann die absolute Position im Bereich von 0 bis 255 Umdrehungen bestimmt werden, wenn der Nulldurchgang des Zählers im zweiten Winkelsensor 13 mit dem Zählvorgang des Zählers im dritten Winkelsensor 15 synchron verläuft. Um diesen Zustand zu erreichen, müsste, wie bei den beschriebenen Lösungen des Standes der Technik, das Getriebe sehr genau gefertigt werden, kein Getriebespiel aufweisen und die permanentmagnetischen Geber müssten bei der Montage sehr genau justiert werden. Haben aber die zweiten und dritten Winkelsensoren 13 und 15 erfindungsgemäß eine Positionsauflösung von mindestens vierundsechzig Inkrementen, ist keine große Genauigkeit des Getriebes erforderlich, es kann ein Getriebespiel vorhanden sein und die ersten, zweiten und dritten permanentmagnetischen Geber 9, 11 und 14 können in beliebiger Winkelstellung montiert werden.

In der Mikroprozessorsteuerung 17 ist außerdem ein Eichprogramm enthalten. Nach der Montage wird das in der Mikroprozessorsteuerung 17 vorhandene Eichprogramm gestartet. Zuerst erfolgt die Ermittlung der Referenzposition zwischen Rotor und Statorwicklung, d. h. die Position des ersten Winkelsensors 10 wird mit der Phasenlage des Statormagnetfeldes verglichen. Damit das Rotormagnetfeld die richtige Phasenlage zum Statormagnetfeld hat, wird die Differenz zwischen der Position des ersten Winkelsensors 10 und der Phasenlage des Statormagnetfeldes als Referenzposition 0 durch definiertes Ansteuern der Statorwicklung ermittelt und im Speicher der Mikroprozessorsteuerung 17 dauerhaft gespeichert. Danach ist die Motorsteuerung für den Eichprozess betriebsbereit. Nach dem Start durchläuft der Motor 18 automatisch den gesamten Umdrehungsbereich, d. h. im Ausführungsbeispiel 255 Umdrehungen, in beiden Drehrichtungen. Dabei werden die Positionsübergänge der einzelnen Kaskaden untereinander erfasst und daraus wird eine Referenzposition für jede Kaskade berechnet und im nichtflüchtigem Speicher der Mikroprozessorsteuerung 17 gespeichert.

Anhand von Tabelle 1 soll nunmehr der Ablauf des Eichprozesses zwischen dem ersten Winkelsensor 10 und dem zweiten Winkelsensor 13 erläutert werden.

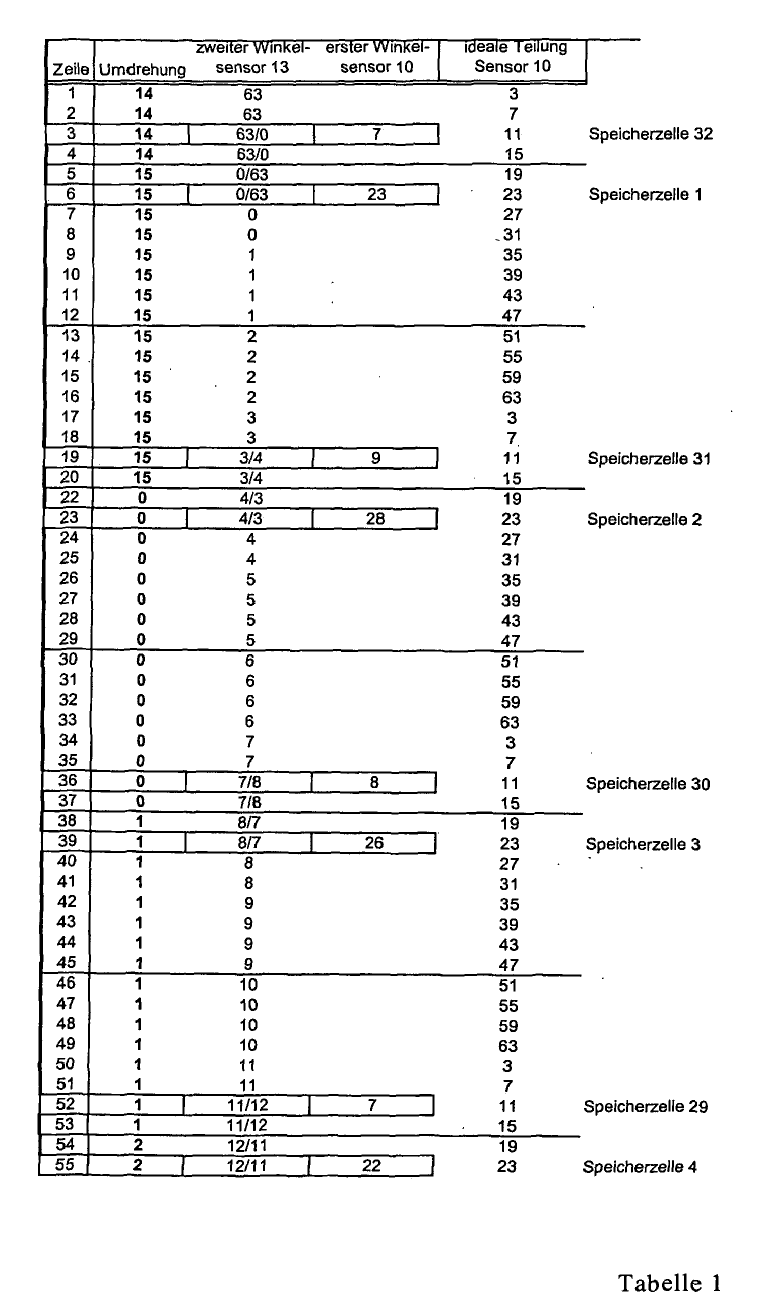

Die Getriebestufen zwischen den ersten, zweiten und dritten permanentmagnetischen Gebern 9, 11 und 14 sind jeweils zweistufig ausgeführt. Damit ergibt sich für die ersten, zweiten und dritten Winkelsensoren 10, 13 und 15 bei einer bestimmten Drehrichtung der Motorwelle 8 die gleiche Zählrichtung ihrer Positionswerte. Die Tabelle 1 zeigt einen Ausschnitt aus dem Eichablauf anhand von drei Umdrehungen der Motorwelle 8, d. h. die Positionen des ersten Winkelsensors 10 wiederholen sich dreimal. Die Mikroprozessorsteuerung 17 wird beim Eichprozess über die serielle Schnittstelle von einem Personalcomputer gesteuert. In der Mikroprozessorsteuerung 17 müssen mindestens 2 oder 32 Speicherzellen für die Positionswerte des ersten Winkelsensors 10 zur Verfügung stehen. Nach dem Start des Motors 18 erfolgt ständig und in kurzen Zeitabständen das Auslesen der Positionswerte des ersten Winkelsensors 10 und des zweiten Winkelsensors 13. Beginnt der Eichablauf z. B. im Rechtslauf der Motorwelle 8 bei Zeile 1 der Tabelle 1 in aufsteigender Reihenfolge, wird die Position des ersten Winkelsensors 10 ständig in Speicherzelle 1 der Mikroprozessorsteuerung 17 geschrieben, solange der zweite Winkelsensor 13 den Positionswert 63 hat. Alte Positionswerte werden dabei überschrieben. Bei den Positionswerten 0, 1, 2 des zweiten Winkelsensors 13 werden keine Positionswerte gespeichert. Wird die Position 3 des zweiten Winkelsensors 13 erreicht, werden die Positionswerte des ersten Winkelsensors 10 in Speicherzelle 2 geschrieben solange der zweite Winkelsensor 13 den Positionswert 3 hat. Dieses Schema wird fortgesetzt bis alle 16 Umdrehungsübergänge durchfahren sind, d. h. im dargestellten Beispiel die Position 60 des zweiten Winkelsensors 13. Damit sind sechzehn Übergangspositionen des ersten Winkelsensors 10 abgespeichert. Danach erfolgt eine Drehrichtungsumkehr und das Speichern der Position des ersten Winkelsensors 10 ab Speicherzelle 17 bei Position 60 des zweiten Winkelsensors 13 nach dem gleichen Schema wie im Rechtslauf. Der Eichlauf des Motors ist beendet, wenn der Positionsübergang von 0 auf 63 erreicht ist. Danach erfolgt eine Berechnung des Mittelwertes aus den Extremwerten der Positionswerte zwischen dem Rechtslauf und dem Linkslauf des Motors, die im dargestellten Beispiel als Referenzposition bezeichnet wird. Der Mittelwert ergibt sich aus den Werten in Speicherzelle 32 und Speicherzelle 2 und beträgt: (7+28) / 2 = 17,5. Es wird die Referenzposition = 17 gezählt, da die minimale Position zweimal vorhanden ist.

Die Bestimmung der Absolutposition erfolgt im allgemeinen beim Stillstand des Motors, und jeweils immer beim Einschalten der Betriebsspannung, und sie wird dabei auf einen inkrementellen Softwarezähler übertragen. Während des Motorlaufs wird der Softwarezähler ständig auf dem aktuellen Wert gehalten. Die Bestimmung der richtigen Umdrehungszahl ist im dargestellten Beispiel immer dann kritisch, wenn sich die Motorwelle 8 im Bereich des Überganges von der einen Umdrehung in die folgende Umdrehung befindet. Im dargestellen Beispiel entsprechend Tabelle 1 sind das die Bereiche der Zeilen 3/6, 19/23, 36/39 und 52/55. In diesen Bereichen wird die Referenzposition mit dem Wert 17 zur Bestimmung der Umdrehung zu Hilfe genommen. Die Referenzposition = 17 teilt den Gesamtbereich des ersten Winkelsensors 10 von vierundsechzig Inkrementen in zwei Teilbereiche: 17 ... 48 und 49 ... 16. Hat der zweite Winkelsensor 13 die Position 2, 3, 4 oder 5 und der erste Winkelsensor 10 eine Position 17 ... 48, befindet sich der Antrieb in der Umdrehung = 0. Hat der zweite Winkelsensor 13 die Position 2, 3, 4 oder 5 und der erste Winkelsensor 10 eine Position 49 ... 16, dann befindet sich der Antrieb in Umdrehung 15. Die Umdrehung kann damit auf ein Inkrement genau vom feiner geteilten ersten Winkelsensor 10 bestimmt werden. Für jede Getriebekaskade muss eine eigene Referenzposition bestimmt und gespeichert werden.

Der Vorteil der Erfindung liegt darin, dass keine hohe Genauigkeit des Getriebes erforderlich ist, dass beliebig viele Getriebestufen kaskadiert werden können, dass die Montage des kompletten Antriebs einfach und unproblematisch erfolgen kann und dass der gesamte Eichprozess automatisch ohne zusätzliche manuelle Arbeiten erfolgen kann.

## Patentansprüche

1. Elektronisch kommutierter Gleichstrom-Servomotor (18), bei welchem ein von der Motorwelle (8) angetriebenes untersetzendes Stirnzahnrad-Messgetriebe (1) mit zur Motorwelle (8) parallel gelagerten ersten, zweiten und gegebenenfalls weiteren Radwellen (25, 27) sowie eine Mikroprozessorsteuerung (17) im Motorgehäuse (30) integriert sind, wobei an der Stirnseite der Motorwelle (8) und mindestens einer Radwelle (25, 27) erste, zweite und gegebenenfalls weitere permanentmagnetische Geber (9, 11, 14) angeordnet sind, denen in relativ geringem Abstand fest angeordnete erste, zweite und gegebenenfalls weitere Winkelsensoren (10, 13, 15) gegenüberliegen, deren Ausgänge mit den Eingängen der Mikroprozessorsteuerung (17) elektrisch verbunden sind,
**dadurch gekennzeichnet,**
**dass** die Positionsauflösung der Winkelsensoren (10, 13, 15) mindestens vierundsechzig Inkremente auf 360° beträgt.

2. Elektronisch kommutierter Gleichstrom-Servomotor (18) nach Anspruch 1,
**dadurch gekennzeichnet,**
**dass** sowohl die Mikroprozessorsteuerung (17) als auch die Winkelsensoren (10, 13, 15) auf einer Leiterplatte (16) angeordnet sind, und die Leiterplatte (16) quer zur Achsrichtung der Motor- und Radwellen (8, 25, 27) mit dem Motor (18) und dem Messgetriebe (1) verbunden ist.

3. Elektronisch kommutierter Gleichstrom-Servomotor (18) nach Anspruch 1 und/oder 2,
**dadurch gekennzeichnet,**
**dass** das Untersetzungsverhältnis des Stirnzahnrad-Messgetriebes (1) von der Motorwelle (8) zur ersten Radwelle (25) des dritten Zahnrades (5) 16:1 und die Untersetzung zwischen der ersten Radwelle (25) des dritten Zahnrades (5) und der zweiten Radwelle (27) ebenfalls 16:1 beträgt.

4. Elektronisch kommutierter Gleichstrom-Servomotor (18) nach mindestens einem der vorhergehenden Ansprüche,
**dadurch gekennzeichnet,**
**dass** in der Mikroprozessorsteuerung (17) ein Eichprogramm enthalten ist, welches bei der Inbetriebnahme des Motors selbstständig die Referenzpositionen zwischen den Winkelsensoren (10, 13, 15) bestimmt und im nichtflüchtigem Speicher der Mikroprozessorsteuerung speichert.
